(19) Europäisches Patentamt
European Patent Office
Office européen des brevets

(11) Publication number: **0 140 376**
**B1**

(12) # EUROPEAN PATENT SPECIFICATION

(45) Date of publication of patent specification: **23.01.91**

(51) Int. Cl.$^5$: **G 03 F 7/022**

(21) Application number: **84113087.5**

(22) Date of filing: **30.10.84**

(54) **Thermally stable positive resist.**

(30) Priority: **02.11.83 US 547780**

(43) Date of publication of application:
**08.05.85 Bulletin 85/19**

(45) Publication of the grant of the patent:
**23.01.91 Bulletin 91/04**

(84) Designated Contracting States:
**BE DE FR GB IT**

(56) References cited:
**EP-A-0 023 662**
**EP-A-0 070 198**
**DE-A-2 751 060**
**DE-A-3 337 315**
**FR-A-2 523 324**

**PATENTS ABSTRACTS OF JAPAN, vol. 6, no. 248 (P-160)1126r, 7th December 1982; & JP-A-57 146 247 (TOKYO SHIBAURA DENKI K.K.) 09-09-1982**

**IBM TECHNICAL DISCLOSURE BULLETIN, vol. 24, no. 12, May 1982, pages 6411-6414, New York, US; E.C. FREDERICKS et al.: "Thermally stable positive diazoquinone resists"**

(73) Proprietor: **OLIN HUNT SPECIALTY PRODUCTS INC.**
**5 Garret Mountain**
**West Paterson, New Jersey 07424 (US)**

(72) Inventor: **Toukhy, Medhat A.**
**7 Congress Road**
**Barrington Rhode Island 02806 (US)**

(74) Representative: **Vossius & Partner**
**Siebertstrasse 4 P.O. Box 86 07 67**
**D-8000 München 86 (DE)**

(56) References cited:
**CHEMICAL ABSTRACTS, vol. 100, no. 16, 16th April 1984, page 556, no. 129771q, Columbus, Ohio, US; NAKAMURA, YOICHI et al.: "Experiment for improving thermal resistance and plasma resistance of positive type photoresist"**

**EP 0 140 376 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:

CHEMICAL ABSTRACTS, vol. 100, no. 20, 14th May 1984, page 559, no. 165344m, Columbus, Ohio, US; SHIRAISHI, HIROSHI et al.: "Radiation chemistry of phenolic resin containing epoxy and azide compounds" & POLYM. PREPR. (AM. CHEM. SOC. DIV. POLYM. CHEM.) 1984, 25(1), 293-4

**Description**

The present invention relates to thermally stable resist compositions useful in ultra violet lithography. More particularly, the present invention relates to a thermally stable, positive resist composition which has the ability to resolve micron size geometries in the fabrication of semiconductor devices.

Resists are materials which, when exposed to high energy, such as electron beam, or radiation of the proper wavelength, such as ultra violet radiation, are chemically changed in their solubility or removability characteristics in certain solvents or developers. To develop a resist generally means to remove, by whatever means, those areas of the resist which are more easily removable after the resist is exposed. A common and convenient means of development is through solvents which dissolve the more easily removable portion of the selectively exposed resist layer, but leave the remaining portions substantially intact. A material is "developable" if it is removable by any of the standard methods of development known to those skilled in the art.

Two types of resists are available, negative-acting and positive-acting resists. Prior to exposure, negative-acting resists are soluble in developer, but with exposure they undergo chemical change and become insoluble in such developers. After selective exposure, the unexposed areas of the resist are selectively dissolved, softened, or washed away, leaving the desired resist pattern on a substrate. The remaining resist pattern is used to protect the substrate in, for example, etching processes, where surface etching of the substrate is desired only in the areas which underlie the unexposed resist.

Positive-acting resists work in the opposite manner, with exposure making the resists soluble in the developer. In either case, the resist pattern that remains after development and, in some cases, post baking, is insoluble and chemically resistant to the cleaning, plating, etching or other solutions used in treating the substrate.

Resists are used in the formation of integrated circuits, printed circuit boards, photolithographs, name plates and the like. Resists are particularly useful in the electronics industry where a typical operation might be the coating of a substrate, such as a silicon wafer with a thin film of a resist which is then exposed through either a positive or a negative of the desired image. If the resist used is a positive-acting material, the exposed areas of the resist layer are rendered soluble by the exposure, and are removed by washing with a developer to uncover the underlying metal layer. The areas surrounding the uncovered metal, which were not exposed remain and protect the portions of the metal layer which they overlie. An etchant to which the resist is impervious may then be used to etch away the uncovered metal areas, or selective plating or other processes may be accomplished, and there remains a layer of resist in the desired image pattern. Later in the manufacturing process, the remaining resist pattern may or may not be removed, as desired.

Modern technology for processing semiconductors, such as plasma etching, sputtering, ion implantation, and the like, requires a photoresist having thermal stability at temperatures of at least about 200°C. A thermally stable photoresist is one which does not flow excessively at a given temperature and one in which images in the resist undergo little or no dimensional changes or distortion at a given temperature. Conventional photoresists are available which are thermally stable at about 160°C, and while they are useful at temperatures up to 160°C, their thermal stability above 160°C is such that they are not suggested for use in the high temperature processing described above.

DE—A—27 51 060 relates to a photosensitive composition for coatings developable by aqueous alkaline solutions which comprises a photosensitive resin, soluble in aqueous alkaline solutions before irradiation and insoluble after irradiation and at least one additive consisting of at least one cellulose ether carboxylic acid ester.

EP—A—0 070 198 describes a radiation-sensitive composition comprising an iodine-containing azide compound at least a part of which can be fixed substantially in a polymer layer by exposure to radiation, and a said polymer substantially having compatibility with said azide compound.

While negative-working resists have been proposed which are stated to have improved thermal properties, positive-working resists have inherent advantages over negative-working resists as is well known to those skilled in the art. Thus a positive-working, thermally stable photoresist would be highly advantageous.

FR—A—2 523 324 refers to positive resist compositions especially useful for light temperature application which comprise a sensitizer which is an ester or an amide of diazide quinone sulfonic acid or carboxylic acid and a bonding material which mainly consists of polyvinylphenol and optionally other additives.

One such thermally stable, positive acting photoresist composition known in the art contains a light-sensitive orthoquinone diazide or orthonaphthoquinone diazide and a polyamic acid condensation product of an aromatic dianhdyride and an aromatic di-primary amine. Such polyamic acid condensation products are converted by heat to a thermally stable polyimide that is water-insoluble, and resistant to dilute acids and organic solvents.

Such positive-acting photoresists are coated on a substrate, dried, exposed through a mask by a suitable actinic light source, such as a 200 watt medium or high pressure mercury arc lamp, developed to remove the exposed resist and then treated to develop the thermal properties of the unexposed resist. In order to fully develop these properties, the unexposed resist is given an allover exposure to actinic light to

decompose the remaining diazide, such as for 60 to 180 seconds at about 3,000 microwatts/$cm^2$, and the polyamic acid condensation product is converted to the polyimide form by heating the photoresist for about 30 minutes at 220°C or higher. The overall exposure step may be omitted if the photoresist is heated slowly during use to avoid rapid decomposition of the diazide.

Thus, there currently exists a need for thermally stable positive resist systems with high resolution and good processing latitude.

Positive resist compositions are provided which are useful in ultra violet lithography. The compositions preferably have a total solids content of from about 15% to about 35% and contain a polymer system comprising a phenolic resin having a weight average molecular weight of at least about 2,000 and preferably a novolak-type resin compatible with the phenolic resin, a sensitizer system comprising a photosensitive agent, which is a diazoketone compound insoluble in aqueous alkaline solution and which absorbs radiation in the near ultra violet region of the spectrum providing decomposition products that are soluble in aqueous alkaline solution, and a thermosensitive cross-linking agent for the phenolic resin, which is a bisarylazide compound that absorbs radiation in the deep ultra violet region of the spectrum and that cross-links the phenolic compound when exposed to elevated temperatures, and a solvent in which all components are readily soluble. The resist compositions of the present invention are developable in aqueous alkaline developers and produce a thermally stable resist which exhibits high resolution.

The resist compositions of the present invention comprise a solution of a sensitizer system and a polymer system in a compatible solvent. The solids content of the composition is preferably between about 15% and about 35%, more preferably between about 20% and about 30%. The polymer system comprises a phenolic resin and may preferably also include a novolak-type resin compatible with the phenolic resin. The polymer system is present in an amount of from about 55% to about 95%, preferably about 65%, by weight of the total solids in the composition.

The phenolic resin has a weight average molecular weight of at least about 2,000, preferably at least about 7,000, more preferably within the range of from about 10,000 to about 40,000, and even more preferably within the range of from about 15,000 to about 30,000, and is present in the composition in an amount of from about 40% to about 100%, preferably about 40% to about 95%, and more preferably about 85%, by weight of the polymer system in the composition. When employed in amounts less than about 100% of the polymer system, the phenolic resin has a weight average molecular weight of at least about 7,000 and the remainder of the polymer system comprises a novolak-type resin.

Phenolic resins useful in the present invention are represented by the following structural formula V:

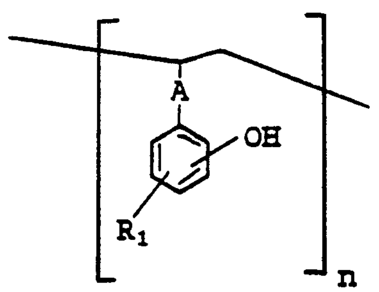 ,

(V)

wherein:

A is a covalent bond, —O—, —C(O)O—, or —C(O)$OCH_2$—, preferably a covalent bond or —O—, and more preferably a covalent bond; and

$R_1$ is —H, —F, —Cl, —Br, or —I, preferably F.

Particularly preferred as the phenolic resin are those resins represented by the following structural formula Va

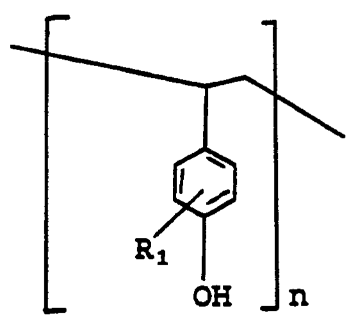

(Va)

wherein $R_1$ has its previously assigned meaning.

The novolak-type resins useful in the present invention can be any such resin which is compatible with the phenolic resin both in coating characteristics, that is, which produces in combination with the phenolic

resin a homogenous and uniform resist coating, and in rate of solubility in the aqueous alkaline developer. Preferred as the novolak-type resin is a cresol-formaldehyde novolak resin or a phenol-formaldehyde novolak resin. The cresol-formaldehyde novolak resins are particularly preferred and are preferably prepared as described in commonly assigned U.S. Patent 4,377,631. The novolak-type resin is present in an amount of from 0 to about 60%, preferably about 5% to about 60%, and more preferably about 15%, by weight of the polymer system in the composition. Novolak-type resins useful in the present invention are represented by the following structural formula VI

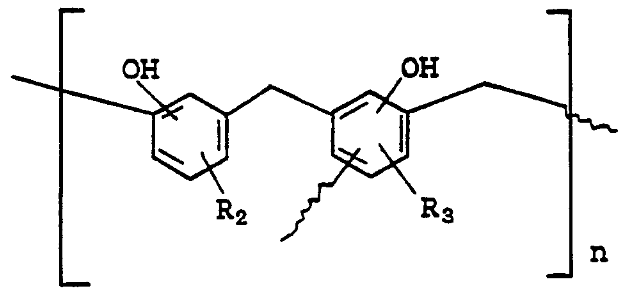

(VI)

wherein:

$R_2$ and $R_3$ are independently monovalent $C_1$ to $C_4$ alkyl, preferably $R_2$ and $R_3$ are methyl.

The thermosensitive cross-linking agent is a bisarylazide compound that absorbs radiation in the deep ultra violet region of the spectrum and that, when exposed to elevated temperatures, typically within the range of from about 80° to about 160°C for from about 10 to about 45 minutes, cross-links the phenolic resin establishing the thermal stability of the resist. Useful bisarylazide compounds are compounds of the formulae I or II

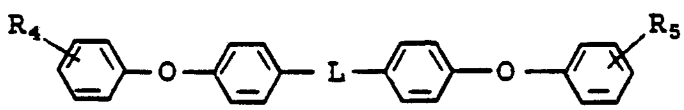

, (I)

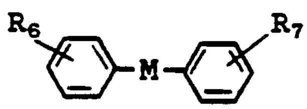

(II)

or a mixture thereof, wherein:

L and M are independently a covalent bond, $-CH_2-$, $-C(CH_3)_2-$, $-CO-$, $-SO_2-$, $-O-$, or $-S-$; and

$R_4$, $R_5$, $R_6$, and $R_7$, are independently $-H$, $-NH_2$ or $-N_3$, provided that at least one of $R_4$ and $R_5$ is $-N_3$ and at least one of $R_6$ and $R_7$ is $-N_3$.

Preferred are those compounds in which L is $-C(CH_3)_2-$, and $R_4$ and $R_5$ are $-N_3$; and those in which M is $-O-$, and $R_6$ and $R_7$ are $-N_3$.

The photosensitive agent is a diazoketone which is insoluble in aqueous alkaline solution and sensitive to radiation in the near ultra violet region of the spectrum, providing, when exposed to such radiation, decomposition products which are soluble in aqueous alkaline solution. Diazoketone compounds useful in the present invention are compounds of the formulae III or IV of

(III) 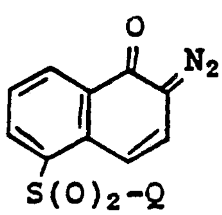 , 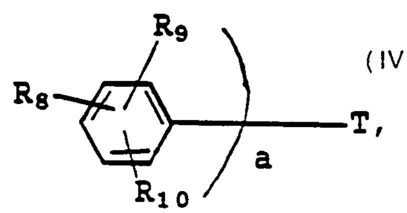 (IV)

or a mixture therof, wherein:

Q is $-E-(CH_2)_2-O-W$ or $-E-C_bX'_{(2b+1)}$;

W s $-CH_3$, $-C_2H_5$, $-(CH_2)_2-O-CH_3$ or $-(CH_2)_2-O-C_2H_5$;

each X' is independently $-H$, $-F$, $-Br$, $-Cl$ or $-I$, preferably each X' is $-H$ or the same halogen ion;

a is 1 or 2;

b is 2, 3, 4, 5, 6, 7, 8 or 9;

T is $-(CO)-$, $-O-$, $-CH_2-$, $-C(CH_3)_2)-$, $-S(O)_2-$, $-S-$, or $-O-Z-O-$, when a is 2; and T is H when a is 1;

Z is $-(CH_2)_2-$ or

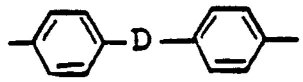 ;

D is —C(O)—, —O—, $—CH_2—$, $—C(CH_3)_2—$, $—S(O)_2—$ or —S—;
each $R_8$, $R_9$ and $R_{10}$ is independently —H, —OH, $—NH_2$,

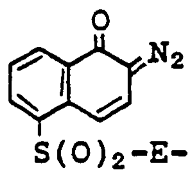 , or 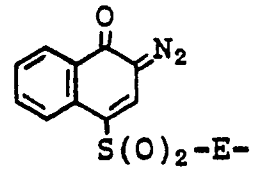 ,

provided: that at least one $R_8$, $R_9$ or $R_{10}$ is

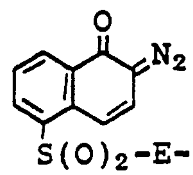

that when T is —O—Z—O—, each $R_{10}$ is H, and that when a is 1, $R_{10}$ is monovalent $C_1$ to $C_9$ alkyl, —H, —OH, $NH_2$, $—C(CH_3)$,

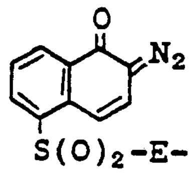 , or 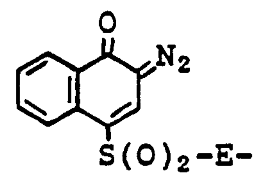 ,

preferably monovalent $C_1$ to $C_9$ alkyl, more preferably $—C(CH_3)_3$; and
each E is independently —O— or —NH—, preferably —O—; when Z is

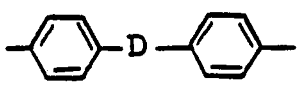 ;

E is preferably —NH—.

Preferably, when a is 2, up to four of the $R_8$, $R_9$ and $R_{10}$ substituents are selected from

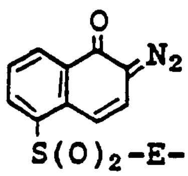 , or 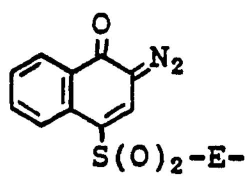 ,

The diazoketone is present in an amount of from about 50% to about 90%, preferably 70%, by weight of the sensitizer system in the composition.

The compositions are formed by adding the components of the polymer system and the sensitizer system to a solvent in which all of the components are readily soluble. The order of addition is not critical. The solvent is preferably an aliphatic ketone, aliphatic ester, alkylene glycol monoalkyl ether, dialkylene glycol monoalkyl ether, alkylene glycol dialkyl ether or a mixture thereof. A particularly preferred class of aliphatic esters are the aliphatic alkylene glycol alkyl ethyl esters. More preferably, the solvent is a cyclohexanone, methylcellosolve acetate, ethylcellosolve acetate, butyl acetate or a mixture thereof. A particularly preferred solvent is a mixture of ethylcellosolve acetate, butylacetate and xylene. The choice of solvent will depend on the specific phenolic resin, novolak-type resin, diazoketone and bisarylazide employed.

After the phenolic resin, the novolak-type resin, the diazoketone and the aromatic azide have been added to the solvent, the mixture is agitated until all solids are dissolved. The resultant resist solution is microfiltered, preferably using a millipore microfiltration system under about 2.1 $Kg/am^2$ (30 pounds per square inch) of pressure of nitrogen or other inert, oxygen-free, ambient atmosphere.

Additives such as dyes, anti-striation agents, plasticizers, adhesion promoters, speed enhancers, and non-ionic surfactants may be added to the solution before it is filtered.

Dye additives useful with the resist compositions of the present invention include Methyl Violet 2B (C.I.

No. 42535), Crystal Violet (C.I. No. 42555), Malachite Green (C.I. No. 42000), Victoria Blue B (C.I. No. 44045) and Neutral Red (C.I. No. 50040) at 0.1% to 3% weight levels, based on the weight of the positive resist composition. The dye additives may help provide increased resolution by inhibiting back scattering of light off the substrate.

Anti-striation agents may be used up to a 5% weight level, based on the weight of the positive resist composition.

Plasticizers which may be used include, for example, phosphoric acid tri-(β-chlorethyl)-ester; stearic acid; dicamphor; acetal resins; phenoxy resins; and alkyd resins at 1% to 5% weight levels, based on the weight of the polymer system. The plasticizers improve the coating properties of the material and enable the application to the substrate of a film that is smooth and of uniform thickness.

Adhesion promoters which may be used include, for example, β-(3,4-epoxy-cyclohexyl)-ethyl-trimethoxysilane; p-methyl-disilane-methyl methacrylate; vinyltrichlorosilane; and γ-amino-propyl triethoxysilane up to a 5% weight level, based on the weight of the positive resist composition.

Speed enhancers that may be used include, for example, picric acid, nicotinic acid or nitrocinnamic acid at a weight level of up to 5%, based on the weight of the total solids. These enhancers tend to increase the solubility of the resist coating in both the exposed and unexposed areas, and thus they are used in applications where speed of development is the overriding consideration even though some degree of contrast may be sacrificed. Thus while the exposed areas of the resist coating will be dissolved more quickly by the developer, the speed enhancers will also cause a larger loss of resist coating from the unexposed areas.

Non-ionic surfactants that may be used include, for example, nonylphenoxy poly(ethyleneoxy) ethanol; octylphenoxy (ethyleneoxy) ethanol; and dinonylphenoxy poly(ethyleneoxy) ethanol at up to 0.5% weight levels, based on the weight of the positive resist composition.

The filtered resist composition can be applied to a substrate by any conventional method used in the resist art, including dipping, spraying, whirling and spin coating. When spin coating is employed, the percent total solids content is selected to provide coatings of the desired thickness given the type of spinning equipment utilized and the spin speed and the amount of time allowed for the spinning process.

The resist coatings produced by the above-described procedure are particularly suitable for application to thermally grown silicon/silicon dioxide-coated wafers, such as are utilized in the production of microprocessors and other miniaturized integrated circuit components, aluminum/aluminum oxide wafers and other wafers typically employed in the art.

After the resist composition is coated onto the substrate, the substrate is baked at about 80° to about 110°C until substantially all the solvent has evaporated and only a thin coating of the resist, on the order of a μm in thickness, remains on the substrate. Typically, the substrate is baked for about 20 to about 45 minutes. Preferably, the substrate is baked at about 90°C for about 30 minutes.

The coated substrate is then imagewise exposed to radiation in the near (about 440 to about 350 nm) to mid (about 360 to about 330 nm) ultra violet ranges of the spectrum, preferably the near ultra violet region, in any desired exposure pattern produced by use of suitable masks, stencils, templates, or the like. The resists can be exposed using commercially available equipment, for example, a Perkin-Elmer 1:1 Projection Micralign III Model or a Kaspar Instruments contact exposure until Model 2001.

The exposed, resist-coated substrates are then contacted with an aqueous alkaline developer, preferably by immersion in the developing solution in, for example, a Teflon tank until all of the resist coating has been dissolved from the imagewise exposed areas. The solution is preferably agitated, for example, by nitrogen burst agitation.

The developer formulation is not critical and typical of the developers useful with the resists of the present invention is HPR-402, an aqueous alkaline positive resist developer manufactured by Philip A. Hunt Chemical Corporation. Typical development conditions are 23 ± 2°C, with the development time depending largely on the exposure energy, developer strength and the developer mode such as spray, puddle, nitrogen burst submersion or mechanical agitation, and pre-bake temperature and time. For example, under mild (magnetic bar) agitation, using 40% HPR-402 developer in the immersion mode, the developing time is typically 60 seconds for 1 μm coatings pre-baked at about 90°C for 30 minutes.

After removal of the coated wafers from the developing solution, the wafers are typically rinsed for about one minute with deionized water, and then a post-development heat treatment or bake is employed which causes the thermosensitive agent to cross-link the phenolic resin, developing the thermal stability of the photoresist. The post-baking can be effected by oven baking of the coating and substrate. Typically, exposing the resist to temperatures within the range of from about 80° to about 160°C for from about 10 to about 45 minutes, cross-links the phenolic resin establishing the thermal stability of the resist. Preferably, the coating is baked at about 125° to about 150°C for about 15 to about 45 minutes, more preferably at about 128°C for about 40 minutes. Particularly preferred is postbaking at about 130°C for about 30 minutes.

In industrial applications, particularly in the manufacture of microcircuitry units on silicon/silicon dioxide-type substrates, the developed substrates are typically treated with a buffered, hydrofluoric acid-based etching solution. The resists of the present invention are resistant to acid-based etching solutions and provide effective protection for the resist-coated areas of the substrate.

The resist compositions of the present invention produce a resist coating which exhibits the thermal stability required by the elevated temperatures employed in the plasma etching, ion milling, and sputtering

processes used in the fabrication of semiconductor devices. The positive resist composition of the present invention does not require the use of deep ultra violet radiation as do currently employed positive resist systems, and develops its thermal stability at a relatively low postbake temperature without post-development exposure to actinic radiation.

## EXAMPLES

The following examples present illustrative but non-limiting embodiments of the present invention. Comparative examples are also provided. Resist film thicknesses in the following examples were measured using a Sloan Dektak Profilometer (hereinafter, "the Profilometer"). The resist coatings in the following examples were exposed using a Perkin-Elmer 1:1 Projection Micralign 111 Model (hereinafter, the "P-E exposure unit") or a Kaspar Instruments contact exposure unit Model 2001 (hereinafter, "the Kaspar exposure unit"). Image dimensions were determined using an I.T.P. Videomicrometer System No. 148 (hereinafter, "the I.T.P. unit"). The Novolak resins employed in the examples were prepared as set forth in U.S. patent 4,377,631.

### Example 1

Sample compositions A through N were prepared as summarized in Table 1. The percentages are by weight of the total solids. The solvent employed in samples A through E and I through M was cyclohexanone; in sample F, a mixture of 41% cyclohexanone and 59% ethylcellosolve acetate; sample G a mixture of about 60% cyclohexanone, about 38% ethylcellosolve acetate, about 1% butyl acetate and about 1% xylene; in sample H, a mixture of about 70% cyclohexanone, about 26% ethylcellosolve acetate, about 2% butyl acetate and about 2% xylene; and in sample N, a mixture of 85% ethylcellosolve acetate, 7.5% butyl acetate, and 7.5% xylene. Sample compositions E and N are comparative. Samples A through H were tested for photospeed and image quality and were found to be relatively slow, whereas samples I through M had a relatively faster photospeed. Microscopic examination of postbaked imaged resists of formulations A through M showed insignificant flow or no flow after 170°C postbake for 30 minutes whereas the comparative compositions exhibited excessive flow.

TABLE 1

| Sample Composition | PVP,% | Novolak,% | | | Diazoketone,% | | | Bisarylazide,% | | | Total Solids,% |
|---|---|---|---|---|---|---|---|---|---|---|---|
| | | $N_1$[5] | $N_2$[6] | $N_3$[7] | $D_1$[8] | $D_2$[9] | $D_3$[10] | $B_1$[11] | $B_2$[12] | $B_3$[13] | |
| A | 65[1] | 10 | - | - | 10 | - | - | - | 15 | - | 25 |
| B | 70[1] | 5 | - | - | 10 | - | - | 15 | - | - | 25 |
| C | 70[1] | 5 | - | - | 10 | - | - | - | - | 15 | 25 |
| D[14] | 70[2] | 5 | - | - | 10 | - | - | 15 | - | - | 26 |
| E | 70[2] | 10 | - | - | - | 20 | - | - | - | - | 27 |
| F | 33.75[2] | 33.75 | - | - | - | - | 15.63 | 16.87 | - | - | 30.5 |
| G | 39.59[3] | 37.82 | - | - | 13.16 | - | - | 9.43 | - | - | 27 |
| H | 67.5[4] | 7.48 | - | - | 10.0 | - | - | 15.02 | - | - | 27 |
| I | 60[1] | 5 | - | - | - | - | 20 | - | - | 15 | 25 |
| J | 60[1] | 5 | - | - | - | - | 20 | - | 15 | - | 25 |
| K | 60[1] | - | 5 | - | - | - | 20 | - | - | 15 | 25 |
| L | 55[1] | 5 | - | - | - | - | 20 | - | - | 15 | 25 |
| M[14] | 50[1] | 5 | - | - | - | - | 30 | - | - | 15 | 25 |
| N | - | - | - | 75 | - | - | 25 | - | - | - | 27.75 |

1. A 30,000 $\overline{M}w$ polyvinylphenol.
2. A 10,000 $\overline{M}w$ polyvinylphenol.
3. A 7,400 $\overline{M}w$ polyvinylphenol.
4. A 4,000 $\overline{M}w$ polyvinylphenol.
5. A novolak resin prepared from a 60% m-cresol, 40% p-cresol mixture and having a softening point of about 136°C.
6. A novolak resin prepared from a 60% m-cresol, 40% p-cresol mixture and having a softening point of about 130° to 133°C.
7. A novolak resin prepared from a 45% m-cresol, 55% p-cresol mixture and having a softening point of about 145°C.
8. A sensitizer prepared by reacting one mole of abielamine with one mole of 2-diazo-1-naphthol-5-sulfochloride.
9. Naphthoquinone(1,2)diazide(2)-5-sulfonic acid O-cresol ester.
10. A sensitizer prepared by reacting about two moles of 2-diazo-1-naphthol-5-sulfochloride with one mole of trihydroxybenzophenone.
11. 3,3'-bisazidodiphenylsulfone.
12. 4,4'-biazidodiphenylmethylene.
13. 4,4'-bisazidooxydiphenyl.
14. Comparative.

Example 2

Sample compositions I through L were evaluated as follows. The samples were spin coated on $Si/SiO_2$ wafers providing a film thickness of about 1 μm, and then prebaked at 70°, 100° or 130°C for 30 minutes. The coatings were exposed for 20 seconds on the Kaspar exposure unit through a multi-density mask to ultra violet radiation in an intensity of 3.2 $m.wt./cm^2$ measured at 380 n.m. and then developed for about 60 seconds, after which the percent film loss and percent transmission of complete development were determined. The processing parameters and results are summarized in Table 2.

TABLE 2

| Sample Composition | Film Thickness, μm | Soft Bake Temp., °C. | Developer[1] Conc., % | Film Loss, % | Transmission of Complete Development, % |
|---|---|---|---|---|---|
| I | 1.09 | 70 | 20 | 6.4 | 20 |
| | 1.09 | 70 | 21 | 6.4 | 20 |
| | 1.09 | 70 | 22 | 6.4 | 20 |
| | 1.09 | 70 | 25 | 19.3 | 14 |
| | 1.09 | 70 | 27 | 28.4 | 12 |
| J | 1.1 | 70 | 25 | 5.45 | 30 |
| | 1.1 | 70 | 27 | 5.45 | 30-35 |
| | 1.1 | 70 | 27 | 3.64 | 30 |
| | 1.04 | 100 | 25 | 3.85 | 40 |
| | 1.04 | 100 | 27 | 5.77 | 35-40 |
| | 1.04 | 100 | 27 | 3.85 | 40 |
| | 0.98 | 130 | 25 | 0 | >100 |
| K | 1.08 | 70 | 25 | 9.26 | 22 |
| | 1.08 | 70 | 27 | 14.81 | 22 |
| | 1.08 | 70 | 30 | 16.67 | 18 |
| | 0.98 | 100 | 25 | 2.04 | 35.40 |
| | 0.98 | 100 | 27 | 4.08 | ~ 35 |
| | 0.98 | 100 | 30 | 10.2 | ~ 25 |
| | 0.93 | 130 | 25 | 1.08 | >100 |
| | 0.93 | 130 | 27 | 0 | >100 |
| | 0.93 | 130 | 30 | 0 | >100 |
| L[2] | 1.02 | 70 | 30 | 1.96 | 22 |
| | 1.02 | 70 | 33 | 5.88 | 20 |
| | 1.02 | 70 | 35 | 1.96 | 18 |
| | 0.96 | 100 | 30 | 2.08 | 35-40 |
| | 0.90 | 130 | 35 | 0 | >100 |

1 LSI developer; a metal ion-containing aqueous alkaline developer available from Philip A. Hunt Chemical Corporation.

2 All of the developed wafers exhibited surface haze.

Example 3

Compositions I, J, K an N were evaluated to determine their thermal stability. The samples were spin coated on Si/$SiO_2$ wafers, providing a film thickness of about 1 micron, prebaked at 100°C for 30 minutes, exposed through a resolution mask on the P-E exposure unit to ultra violet radiation at constant intensity measured at 356 n.m. The wafers were developed for about 60 seconds using an aqueous alkaline developer, postbaked and then subjected to electron microscopic examination and examination on the I.T.P. unit. Examination of the samples showed some changes in image slope and top roundness with increasing postbake temperature. The greatest change in profile was seen at 150°C suggesting that at this temperature or lower, cross-linking of the resist occurred yielding a more thermally stable geometry. This was confirmed by the observed stability in image dimensions after postbaking at 128°C for 30 minutes. Generally, window dimensions appeared to increase after postbaking at 128° to 130°C but to decrease after postbaking at 150°C. When samples I, J, K were postbaked at 128°C for 30 minutes and then at 200°C for 30 minutes, no dimensional changes were observed between these two postbake temperatures, whereas comparative sample N exhibited excessive flow. The results are summarized in Table 3.

**TABLE 3**

| Sample Composition | Film Thickness, µm | Scan Setting | Developer[1] Conc., % | Film Loss, % | D.I.D.[2] | $I.D._1$ [3] | $I.D._2$ [4] | $I.D._3$ [5] | $I.D._4$ [6] | $I.D._5$ [7] |
|---|---|---|---|---|---|---|---|---|---|---|
| I | 1.06 | 200 | 22 | 4.9 | 4.89 | 5.06 | 5.04 | 5.03 | 5.07 | 4.49 |
| | | 225 | 22 | 4.9 | 4.89 | 5.19 | -- | -- | -- | 4.56 |
| | | 250 | 22 | 4.9 | 4.82 | -- | -- | -- | -- | -- |
| | | 290 | 22 | 4.9 | 4.48 | -- | -- | -- | -- | -- |
| | | 350 | 25 | 12.5 | 5.03 | -- | -- | -- | -- | -- |
| J | -- | 225 | 27 | 8.6 | 5.12 | -- | -- | -- | -- | -- |
| | | 250 | 27 | 8.6 | 5.08 | 5.27 | -- | -- | -- | 4.62 |
| | | 250 | 27 | 8.6 | 5.08 | 5.27 | 5.27 | -- | -- | -- |
| | | 290 | 27 | 8.6 | 4.78 | -- | -- | -- | -- | -- |
| K | 1.07 | 250 | 25 | 10.2 | 5.06 | 5.21 | 5.16 | 5.17 | 5.15 | 4.5 |
| | | 275 | 25 | 10.2 | 5.22 | -- | -- | -- | -- | -- |
| | | 300 | 25 | 10.2 | 4.98 | 5.12 | -- | -- | -- | 4.43 |
| | | 350 | 25 | 10.2 | 4.66 | -- | -- | -- | -- | -- |
| N | -- | 350 | 50 | -- | 5.03 | 5.23 | -- | -- | -- | 4.48 |
| | | 350 | 50 | -- | 4.97 | 5.08 | 4.61 | Excessive flow | | 4.51 |

1. LSI developer; a metal ion-containing aqueous alkaline developer available from Philip A. Hunt Chemical Corporation.
2. D.I.D. = developed image dimension; nominal of 5µm window.
3. $I.D._1$ = image dimension after postbake at 128°C. for 30 min.; nominal of 5µm window.
4. $I.D._2$ = image dimension after postbake at 128°C. for 30 min., then at 150°C. for an additional 30 min.; nominal of 5µm window.
5. $I.D._3$ = image dimension after postbake for 30 min. at 128°C., 30 min. at 150°C., and then 30 min. at 175°C.; nominal of 5µm window.
6. $I.D._4$ = final image dimension after postbake for 30 min. at each of the following temperatures: 128°C., 150°C., 175°C. and 200°C.; nominal of 5µm window.
7. $I.D._5$ = image dimension after postbake for 30 min. at 150°C.; nominal of 5µm window.

Example 4

Sample compositions O through X were prepared as summarized in Table 4. The percentages are by weight of the total solids and the solvent employed was a mixture of 85% ethylcellosolve acetate, 7.5% butyl acetate and 7.5% xylene. Sample X is comparative.

TABLE 4

| Sample Composition | PVP,[2] % | Novolak, % | | | Diazoketone, % | | Bisarylazide, % | Total Solids, % |
|---|---|---|---|---|---|---|---|---|
| | | $N_4$[3] | $N_5$[4] | $N_6$[5] | $D_4$[6] | $D_5$[7] | $B_4$[8] | |
| O | 55 | 10 | - | - | 20 | 5 | 10 | 26 |
| P | 55 | 10 | - | - | 25 | - | 10 | 24.5 |
| Q | 55 | - | 10 | - | 20 | - | 10 | 26 |
| R | 59.15 | 10.85 | - | - | 20 | - | 10 | 26 |
| S | 45 | 25 | - | - | 20 | - | 10 | 26 |
| T | 45 | 25 | - | - | 16 | 4 | 10 | 26 |
| U | 46 | - | - | 25 | 20 | - | 10 | 26 |
| V | 55 | 10 | - | - | 20 | 5 | 10 | 26 |
| W | 55 | 10 | - | - | 25 | - | 10 | 26 |
| X[1] | - | 75 | - | - | 25 | - | - | 27.75 |

1. Comparative.
2. A 24,000 $\bar{M}w$ polyvinylphenol.
3. Novolak prepared from a mixture of 60% m-cresol and 40% p-cresol and having a softening point of about 130° to 133°C.
4. Novolak prepared from a mixture of m-cresol and catechol and having a softening point of about 171°C.
5. Novolak prepared from a mixture of 50% m-cresol and 50% p-cresol and having a softening point of about 140°C.
6. A sensitizer prepared by reacting about two moles of 2-diazo-1-naphthol-5-sulfochloride with one mole of trihydroxybenzophenone.
7. Naphthoquinone(1,2)diazide(2)-4-sulfonic acid cumylphenol ester.
8. 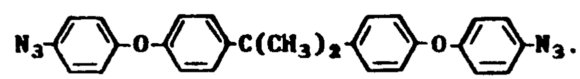

Example 5

Sample compositions P, V and W were spin coated on Si/$SiO_2$ wavers providing a film thickness of about 1 µm, prebaked at about 100°C for about 30 minutes, and then developed for about 60 seconds, without having been exposed to ultra violet radiation, to determine the ability of the unexposed films to withstand aqueous alkaline developers. The process parameters and film loss are summarized in Table 5.

TABLE 5

| Sample Composition | Spin Speed, rpm | Prebaked film thickness, μm | Developer Conc., %[1] | Developed film thickness, μm | Film Loss (unexposed) $10^{-10}$ m | % |
|---|---|---|---|---|---|---|
| P | 3700 | 1.0073 | 44 | 0.9133 | 940 | 9.3 |
| V | 5000 | 0.94 | 42 | 0.90 | 400 | 4.3 |
| W[2] | 5000 | 0.986 | 44 | 0.879 | 1070 | 10.9 |

1 HPR-402; an aqueous alkaline positive resist developer available from Philip A. Hunt Chemical Corporation.

2 Identical components to P but higher percentage of total solids.

Example 6

Sample compositions P, V and W were spin coated on Si/$SiO_2$ wafers providing a film thickness of about 1 μm, prebaked as summarized in Example 5, exposed through a resolution mask on the P-E exposure unit to near ultra violet radiation at the energies indicated in Table 6 (measured at 356 n.m.), developed for about 60 seconds, postbaked at either 130°C for 30 minutes, or at 130°C for 30 minutes followed by 200°C for 30 minutes, and then examined using the I.T.P. unit to determine image dimensions. These dimensions were compared to image dimensions measured before postbaking. The process parameters and the results are summarized in Table 6.

**TABLE 6**

| Sample Composition | Exposure Energy, mj/cm$^2$ | Developer[1] Conc., % | Developed image dimension, μ | Postbaked image dimension, μ 130°C/30 min. | Postbaked image dimension, μ 130°C/30 min. + 200°C/30 min. |
|---|---|---|---|---|---|
| P | 143 | 44 | 4.96 | 4.97 | 4.94 |
| V | 230 | 42 | 5.03 | 4.99 | 5.06 |
| W | 110 | 44 | 5.03 | 5.00 | 4.95 |

1. HPR-402; an aqueous alkaline positive resist developer available from Philip A. Hunt Chemical Corporation.

Example 7

Sample compositions P through V, and X were spin coated on Si/$SiO_2$ wavers to provide the film thicknesses indicated below in Table 7, prebaked at 100°C for 30 minutes, exposed through a resolution mask on the P-E exposure unit, to near ultra violet radiation at the energies indicated in Table 7 (measured at 356 n.m.) then developed for about 60 seconds. The resists were evaluated for film loss and developed image dimension employing the I.T.P. unit, the Profilometer, and a scanning electron microscope. The process parameters and results are summarized in Table 7.

**TABLE 7**

| Sample Composition | Film Thickness, μm | Exposure Energy, mj/cm² | Developer Concentration, % | | Developed Film Thickness, μm | Developed Image Dimension[5] | Film Loss, $10^{-10}$ μm |
|---|---|---|---|---|---|---|---|
| | | | Dv[1] | Dv[2] | | | |
| P | 1.03 | 120 | - | 44 | 0.93 | 5.04 | 1033 |
| Q | 1.167 | 135 | - | 42 | 1.05 | 5.03 | 700 |
| R | 1.09 | 149 | - | 40 | 0.983 | 4.96 | 1067 |
| S | 0.99 | 281 | - | 40 | 0.96 | 5.01 | 367 |
| T | 1.0 | 245 | - | 46 | 0.94 | 5.06 | 600 |
| U | 1.01 | 315 | - | 36 | 0.965 | 4.93 | 450 |
| V | 0.98 | 96 | 27 | - | 0.89 | 5.05 | 900 |
| | 0.98 | 165 | - | 42 | 0.93 | 5.00 | 500 |
| X[3] | 0.9767 | 35 | 50 | - | 0.903 | 4.91[4] | 734 |

1. MIF; a metal ion-free aqueous alkaline developer available from Philip A. Hunt Chemical Corporation.
2. HPR-402; an aqueous alkaline positive resist developer available from Philip A. Hunt Chemical Corporation.
3. Comparative.
4. Pronounced foot.
5. Nominal of 5μm.

Example 8

The plasma etch rates of sample composition O and comparative sample compositions X, Y and Z were determined using a $CHF_3$ plasma environment as is typically employed for $SiO_2$ etching and an $SF_6$ plasma environment as is typically employed for nitride and polysilicone etching. As controls, uncoated $SiO_2$, nitride, and polysilicone surfaces were also etched. The compositions were spin coated on $SiO_2$ wafers at a thickness of about 1 µm, prebaked at 100°C for 30 minutes, postbaked at the temperature indicated in Table 8 and then etched in either the $CHF_3$ or $SF_6$ plasma environment. The etch rate was determined at different settings. The process parameters and results are summarized below in Table 8.

**TABLE 8**

| Sample Composition | Postbake Temp., °C | Gas | Etch Rate, $10^{-10}$ m/min., at 20watts | 25watts | 30watts | 50watts | 100watts |
|---|---|---|---|---|---|---|---|
| Control [1] | - | $CHF_3$ | - | 700 | - | - | - |
| Control [2] | - | $SF_6$ | - | - | 800 | - | - |
| Control [3] | - | $SF_6$ | 2000 | - | - | - | |
| 0 | 200 | $CHF_3$ | - | 250 | - | 320 | 360 |
| 0 | 130 | $SF_6$ | - | 1670 | - | 3220 | 4390 |
| 0 | 90 | $SF_6$ | - | 1670 | - | 4000 | -[7] |
| X[4] | 250 | $CHF_3$ | - | 150 | - | 240 | 400 |
| X[4] | 130 | $SF_3$ | - | 1660 | - | 3015 | -[7] |
| X[4] | 250 | $SF_6$ | - | 1790 | - | 3015 | 4020 |
| X[4] | 90 | $SF_6$ | - | 1670 | - | -[7] | -[7] |
| Y[5] | 130 | $SF_6$ | - | 1855 | - | 4020 | 4825 |
| Z[6] | 130 | $SF_6$ | - | 1670 | - | 3015 | -[7] |

1. Uncoated $SiO_2$ wafer.
2. Uncoated nitride surface.
3. Uncoated polysilicone surface.
4. Comparative.
5. KTI-802; a positive resist composition available from Kodak; comparative
6. OFPR-800; a posisitve resist composition available from Dynachem; comparative.
7. Severely attacked.

**Claims**

1. A positive resist composition, comprising a sensitizer system, a polymer system, and a solvent for the sensitizer system and the polymer system, the polymer system comprising a phenolic resin having a weight average molecular weight of at least about 2,000, characterized in that the sensitizer system comprises a photosensitive agent and a thermosensitive cross-linking agent for the phenolic resin, wherein the photosensitive agent comprises a diazoketone compound insoluble in aqueous alkaline solution that absorbs radiation in the near ultra violet region of the spectrum providing decomposition products soluble in aqueous alkaline solution, and the thermosensitive cross-linking agent comprises a bisarylazide compound that absorbs radiation in the deep ultra violet region of the spectrum and that cross-links the phenolic resin when exposed to elevated temperatures.

2. The composition of claim 1 wherein the polymer system includes a novolak-type resin and the phenolic resin has a weight average molecular weight of at least about 7,000.

3. The composition of claim 1, wherein the polymer system comprises, by weight, about 40% to about 100% of the phenolic resin and from 0% to about 60% of a novolak-type resin compatible with the phenolic resin, wherein the polymer system comprises about 55% to about 95%, by weight, of the total solids in the composition, wherein the sensitizer system comprises, by weight, from about 50% to about 90% of the photosensitive agent and from about 10% to about 50% of the thermosensitive cross-linking agent for the phenolic resin, and wherein the photosensitive agent is the diazoketone compound and the thermosensitive cross-linking agent is the bisarylazide compound.

4. The composition of claims 1 or 3 wherein the bisarylazide compound is a compound of the formulae I or II

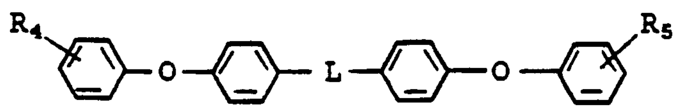 , (I)

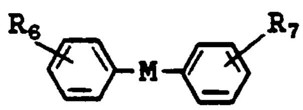 (II)

or a mixture thereof, wherein:

L and M are independently a covalent bond, $—CH_2—$, $—C(CH_3)_2—$, $—SO_2—$, —CO—, —O—, or —S—; and

$R_4$, $R_5$, $R_6$, and $R_7$ are selected independently from —H, $—NH_2$ and $—N_3$, provided that at least one of $R_4$ and $R_5$ is $—N_3$, and at least one of $R_6$ and $R_7$ is $—N_3$.

5. The composition of claims 1 or 3 wherein the diazoketone compound is a compound of the formulae III or IV

(III) 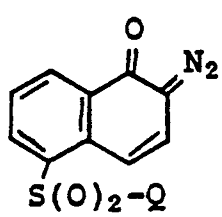 , 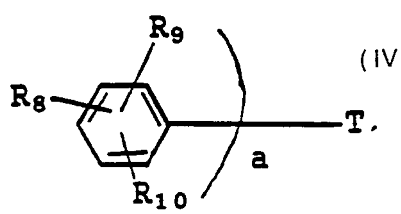 (IV)

or a mixture thereof, wherein:

Q is $—E—(CH_2)_2—O—W$ or $—E—C_bX'_{(2b+1)}$;

W is $—CH_3$, $—C_2H_5$, $—(CH_2)_2—O—CH_3$ or $—(CH_2)_2—O—C_2H_5$;

each X' is independently —H, —F, Br—, —Cl or —I;

a is 1 or 2;

b is 2, 3, 4, 5, 6, 7, 8 or 9;

T is —(CO)—, —O—, $—CH_2—$, $—C(CH_3)_2)—$, $—S(O)_2—$, —S—, or —O—Z—O—, when a is 2; and T is H when a is 1;

Z is $—(CH_2)_2—$ or

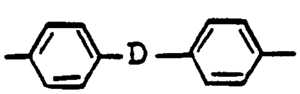 ;

D is —C(O)—, —O—, $—CH_2—$, $—C(CH_3)_2—$, $—S(O)_2—$ or —S—;

each $R_8$, $R_9$ and $R_{10}$ is independently —H, —OH, $NH_2$,

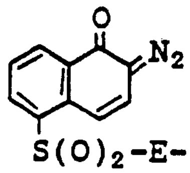

, or

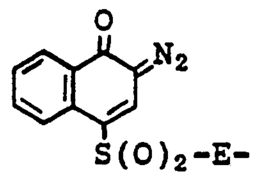

,

provided: that at least one $R_8$, $R_9$ or $R_{10}$ is

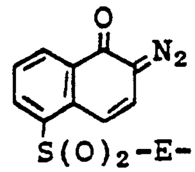

that when T is —O—Z—O—, each $R_{10}$ is H, and that when a is 1, $R_{10}$ is monovalent $C_1$ to $C_9$ alkyl, —$C(CH_3)_3$, —H, —OH, —$NH_2$,

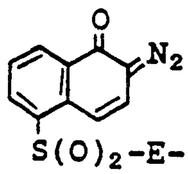

, or

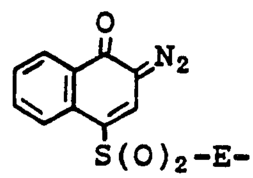

,

and each E is independently —O—, or —NH—.

6. The composition of claims 1 or 3 wherein the phenolic resin is represented by the following structural formula V:

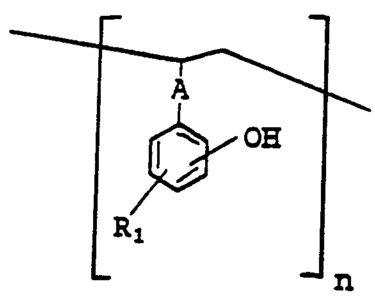

, (V)

wherein:

A is a covalent bond, —O—, —C(O)O—, or —C(O)OCH$_2$—; and

$R_1$ is —H, —F, —Cl, —Br or —I.

7. The composition of claims 1 or 3 wherein the novolak-type resin is represented by the following structural formula VI:

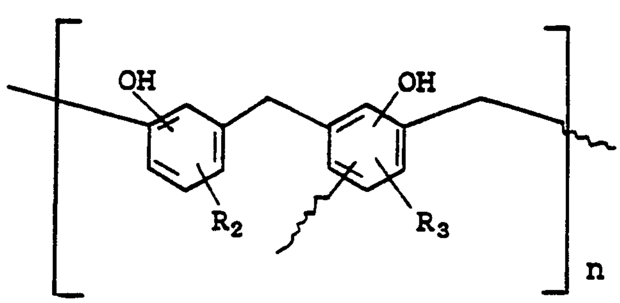

(VI)

wherein:

$R_2$ and $R_3$ are independently monovalent $C_1$ to $C_4$ alkyl.

8. The composition of claims 1 to 3 wherein the phenolic resin has a weight average molecular weight of at least about 7,000, the phenolic resin is present in the composition in an amount of from about 40% to about 95% by weight of the polymer system in the composition, and the novolak-type resin is present in an amount of from about 5% to about 60% by weight of the polymer system in the composition.

9. The composition of claims 1 or 3 wherein the total solids content of the composition is within the range of from about 15% to about 35%.

10. The composition of claim 1, wherein the total solids content is from about 15% to about 35%, wherein the polymer system comprises, by weight, about 40% to about 95% of the phenolic resin having a weight average molecular weight of at least about 7,000, and about 5% to about 60% of the novolak-type resin compatible with the phenolic resin, wherein the polymer system comprising about 55% to about 95%, by weight, of the total solids in the composition, wherein the phenolic resin is represented by the structural formula V according to claim 6, the novolak-type resin is represented by the structural formula VI according to claim 7, the sensitizer system comprises, by weight, from about 10% to about 50% of the thermosensitive crosslinking agent for the phenolic resin and from about 50% to about 90% of the photosensitive agent, the thermosensitive cross-linking agent is a bisarylazide compound of the formulae I or II according to claim 4 or a mixture thereof, and the photosensitive agent is a diazoketone compound of the formulae III or IV according to claim 5 or a mixture thereof.

11. The composition of any one of claims 1 to 10 wherein the solvent is an aliphatic ketone, aliphatic ester, alkylene glycol monoalkyl ether, dialkylene glycol monoalkyl ether, alkylene glycol dialkyl ether, or a mixture thereof.

12. The composition of any one of claims 1 to 10 wherein the solvent is a mixture of ethylcellusolve acetate, butyl acetate and xylene.

13. The composition of any one of claims 1 to 10 wherein the polymer system comprises, by weight, about 15% of the novolak-type resin and about 85% of the phenolic resin.

14. The composition of any one of claims 1 to 10 wherein the sensitizer system comprises, by weight, about 70% of the diazoketone compound and about 30% of the bisarylazide compound.

15. The composition of any one of claims 1 to 10 wherein the polymer system comprises about 65% by weight of the total solids in the composition.

16. A photosensitive material, comprising a support having coated thereon a layer comprising the composition of claim 1, 3 or 10.

17. A method of forming a thermally stable photoresist image, comprising imagewise exposing the photosensitive material of claim 16 to near ultra violet radiation, developing a positive relief image by contacting the exposed layer with an aqueous alkaline developer thereby removing the imagewise exposed areas, and then exposing the remaining photosensitive material to elevated temperature to develop the thermal stability of the photoresist.

18. The method of claim 17 wherein the remaining photoresist material is exposed to a temperature within the range of from about 80° to about 160°C for from about 10 to about 45 minutes.

**Patentansprüche**

1. Positive Abdecklack-Zusammensetzung, umfassend ein Sensibilisatorsystem, ein Polymersystem und ein Lösungsmittel für das Sensibilisatorsystem und das Polymersystem, wobei das Polymersystem ein Phenolharz mit einem Gewichtsmittel des Molekulargewichts von mindestens etwa 2000 umfaßt, dadurch gekennzeichnet, daß das Sensibilitatorsystem ein lichtempfindliches Mittel und ein hitzeempfindliches Vernetzungsmittel für das Phenolharz umfaßt, wobei das lichtempfindliche Mittel eine in wäßriger alkalischer Lösung unlösliche Diazoketon-Verbindung umfaßt, die Strahlung im nahen Ultraviolett-Bereich des Spektrums absorbiert, wobei in wäßriger alkalischer Lösung lösliche Zersetzungsprodukte entstehen, und das hitzeempfindliche Vernetzungsmittel eine Bisarylazid-Verbindung umfaßt, die Strahlung im tiefen Ultraviolet-Bereich des Spektrums absorbiert und die das Phenolharz vernetzt, wen sie erhöhten Temperaturen ausgesetzt wird.

2. Zusammensetzung nach Anspruch 1, in der das Polymersystem ein Harz vom Novolak-Typ einschließt und das Phenolharz ein Gewichtsmittel des Molekulargewichts von mindestens etwa 7000 aufweist.

3. Zusammensetzung nach Anspruch 1, in der das Polymersystem, bezogen auf das Gewicht, etwa 40 bis etwa 100% des Phenolharzes und 0% bis etwa 60% eines mit dem Phenolharz verträglichen Harzes vom Novolak-Typ umfaßt, wobei das Polymersystem etwa 55 bis etwa 95 Gew.-% der gesamten Feststoffe der Zusammensetzung umfaßt, wobei das Sensibilisatorsystem, bezogen auf das Gewicht, etwa 50 bis etwa 90% des lichtempfindlichen Mittels und etwa 10 bis etwa 50% des hitzeempfindlichen Vernetzungsmittels für das Phenolharz umfaßt, und wobei das lichtempfindliche Mittel die Diazoketon-Verbindung und das hitzeempfindliche Vernetzungsmittel die Bisarylazid-Verbindung ist.

4. Zusammensetzung nach Ansprüchen 1 oder 3, wobei die Bisarylazid-Verbindung eine Verbindung der Formeln I oder II

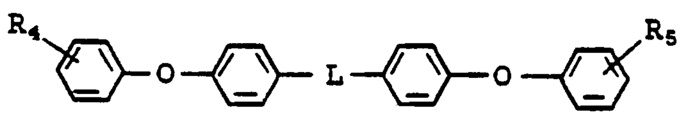 , (I)

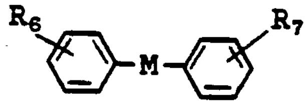 (II)

oder ein Gemisch davon ist, wobei

L und M unabhängig voneinander eine kovalente Bindung $—CH_2—$, $—C(CH_3)_2—$, $—SO_2—$, $—CO—$, $—O—$ oder $—S—$ bedeuten; und

$R_4$, $R_5$, $R_6$ und $R_7$ unabhängig voneinander $—H$, $—NH_2$ oder $—N_3$ darstellen, mit der Maßgabe, daß mindestens einer der Reste $R_4$ und $R_5$ $—NH_3$ bedeutet und mindestens einer der Reste $R_6$ und $R_7$ $—NH_3$ bedeutet.

5. Zusammensetzung nach dem Ansprüchen 1 oder 3, wobei die Diazoketon-Verbindung eine Verbindung der Formeln III oder IV

(III) 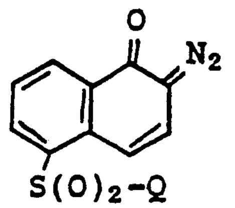 , 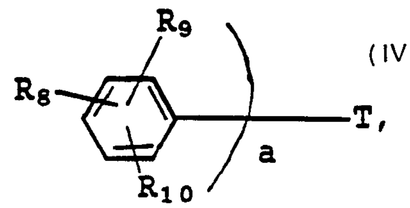 (IV)

oder ein Gemisch davon ist, wobei

Q $—E—(CH_2)_2—O—W$ oder $—E—C_bX'_{(2b+1)}$ ist;

W $—CH_3$, $—C_2H_5$, $—(CH_2)_2—O—CH_3$ oder $—(CH_2)_2—O—C_2H_5$ ist;

jedes X' unabhängig —H, —F, —Br, —Cl oder —I bedeutet;

a 1 oder 2 ist

b 2, 3, 4, 5, 6, 7, 8 oder 9 ist;

T $—(CO)—$, $—O—$, $—CH_2—$, $—C(CH_3)_2—$, $—S(O)_2—$, $—S—$ oder $—O—Z—O—$ ist, wenn a 2 ist; und T H ist, wenn a 1 ist;

Z $—(CH_2)_2—$ oder

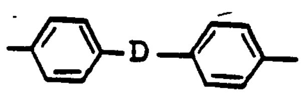 ;

ist;

D $—C(O)—$, $—O—$, $—CH_2—$, $—C(CH_3)_2—$, $—S(O)_2—$ oder $—S—$ ist;

jeder der Reste $R_8$, $R_9$ und $R_{10}$ unabhängig —H, —OH, $NH_2$;

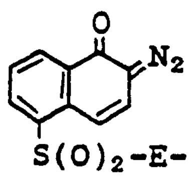 oder 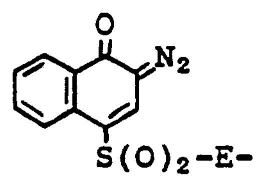 ,

ist, mit der Maßgabe, daß mindestens einer der Reste $R_8$, $R_9$ oder $R_{10}$

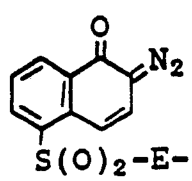

ist, daß jedes $R_{10}$ H ist, wenn T $—O—Z—O—$ bedeutet, und daß $R_{10}$ ein einwertiger $C_1$- bis $C_9$-Alkylrest, $—C(CH_3)_3$, —H, —OH, $—NH_2$,

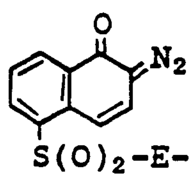 oder 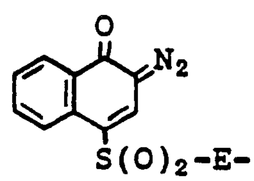 ,

ist; und jedes E unabhängig —O— oder —NH— bedeutet, wenn a 1 ist.

6. Zusammensetzung nach Anspruch 1 oder 3, in de das Phenolharz durch die folgende Strukturformel V wiedergegeben wird

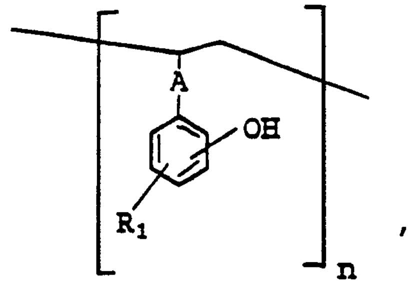

(V)

in der

A eine kovalente Bindung, —O—, —C(O)O— odre —C(O)OCH$_2$— bedeutet; und

$R_1$ —H, —F, —Cl, —Br oder —I ist.

7. Zusammensetzung nach Anspruch 1 oder 3, wobi das Harz vom Novolak-Typ durch die folgende Strukturformel VI wiedergegeben wird

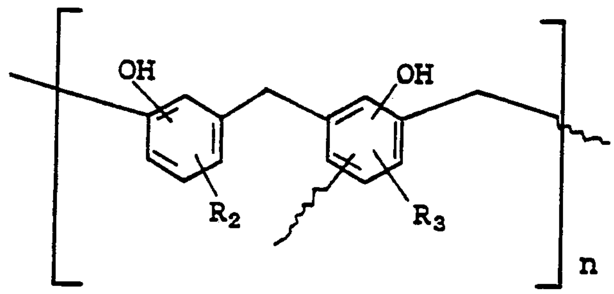

(VI)

in der

$R_2$ und $R_3$ unabhängig einwertige $C_1$- bis $C_4$-Alkylreste bedeuten.

8. Zusammensetzung nach Anspruch 1 oder 3, in der das Phenolharz ein Gewichtsmittel des Molekulargewichts von mindestens etwa 7000 aufweist, das Phenolharz in der Masse in einer Menge von etwa 40 bis etwa 95 Gew.-% des Polymersystems in der Masse vorhanden ist, und das Harz vom Novolak-Typ in einer Menge von etwa 5 bis etwa 60 Gew.-% des Polymersystems in der Masse vorhanden ist.

9. Zusammensetzung nach Anspruch 1 oder 3, wobei de gesamte Feststoffgehalt der Masse im Bereich von etwa 15 bis etwa 35% liegt.

10. Masse nach Anspruch 1, in der der gesamte Feststoffgehalt etwa 15 bis etwa 35% beträgt, wobei das Polymersystem bezogen auf das Gewicht etwa 40 bis etwa 95% des Phenolharzes mit einem Gewichtsmittel des Molekulargewichts von mindestens etwa 7000 und etwa 5 bis etwa 60% des mit dem Phenolharz verträglichen Harzes von Novolak-Typ umfaßt, wobei das Polymersystem etwa 55 bis etwa 95 Gew.-% der gesamten Feststoffe der Masse umfaßt, wobei das Phenolharz durch die Strukturformel V nach Anspruch 6 und das Harz vom Novolak-Typ durch die Strukturformel VI nach Anspruch 7 wiedergegeben wird, das Sensibilisatorsystem, bezogen auf das Gewicht, etwa 10 bis etwa 50% des hitzeempfindlichen Vernetzungsmittels für das Phenolharz und etwa 50 bis etwa 90% des lichtempfind-ichen Mittels umfaßt, das hitzeempfindliche Vernetzungsmittel eine Bisarylazid-Verbindung der Formeln I oder II nach Anspruch 4 oder ein Gemisch davon ist, und das lichtempfindliche Mittel eine Diazoketon-Verbindung der Formeln III oder IV nach Anspruch 5 oder ein Gemisch davon ist.

11. Zusammensetzung nach einem der Ansprüche 1 bis 10, wobei das Lösungsmittel ein aliphatisches Keton, ein aliphatischer Ester, ein Alkylenglykol-Monoalkylether, ein Dialkylenglykol-Monoalkylether, ein Alkylenglykol-Dialkylether oder ein Gemisch davon ist.

12. Zusammensetzung nach einem der Ansprüche 1 bis 10, in der das Lösungsmittel ein Gemisch von Ethylcellosolveacetat, Butylacetat und Xylol ist.

13. Zusammensetzung nach einem der Ansprüche 1 bis 10, in der das Polymersystem, bezogen auf das Gewicht, etwa 15% des Harzes vom Novolak-Typ und etwa 85% des Phenolharzes umfaßt.

14. Zusammensetzung nach einem der Ansprüche 1 bis 10, wobei das Sensibilisatorsystem, bezogen auf das Gewicht, etwa 70% der Diazoketon-Verbindung und etwa 30% der Bisarylazid-Verbindung umfaßt.

15. Zusammensetzung nach einem der Ansprüche 1 bis 10, in der das Polymersystem etwa 65 Gew.-% der gesamten Feststoffe der Zusammensetzung umfaßt.

16. Lichtempfindliches Material, umfassend einen Träger und darauf aufgebracht eine Schicht, die die Zusammensetzung nach Anspruch 1, 3 oder 10 umfaßt.

17. Verfahren zur Herstellung eines hitzebeständigen Photoresist-Bildes, umfassend die Bildweise Belichtung des lichtempfindlichen Materials nach Anspruch 16 mit naher Ultraviolett-Strahlung, Entwicklung eines positiven Reliefbildes durch Zusammenbringen der belichteten Schicht mit einem

wäßrien alkalischen Entwickler, wobei die bildweise belichteten Bereiche entfernt werden, und dann Aussetzen des verbliebenen lichtempfindlichen Materials einer erhöhten Temperatur zur Entwicklung der thermischen Stabilität des Photoresists.

18. Verfahren nach Anspruch 17, wobei das verbleibende Photoresist-Material etwa 10 bis etwa 45 Minuten einer Temperatur im Bereich von etwa 80 bis etwa 160°C ausgesetzt wird.

**Revendications**

1. Une composition de réserve positive, comprenant un système sensibilisateur, un système de polymères et un solvant pour le système sensibilisateur et le système de polymères, le système de polymères comprenant une résine phénolique ayant un poids moléculaire moyen en poids d'au moins environ 2 000, caractérisée en ce que le système sensibilisateur comprend un agent photosensible et un agent réticulant thermosensible pour la résine phénolique, dans lequel l'agent photosensible comprend une diazocétone insoluble en solution aqueuse alcaline qui absorb les radiations dans la région du proche ultra-violet en donnant des produits de décomposition solubles en solution aqueuse alcaline, et l'agent réticulant thermosensible comprend un bisarylazide qui absorbe les radiations dans la région de l'ultraviolet lointain et qui réticule la résine phénolique par exposition à des températures élevées.

2. La composition selon la revendication 1, dans laquelle le système de polymères comprend une résine du type novolaque et la résine phénolique a un poids moléculaire moyen en poinds d'au moins environ 7 000.

3. La composition selon la revendication 1, dans laquelle le système de polymères comprend environ 40 à environ 100% en poids de la résine phénolique et de 0 à environ 60% en poids d'une résine du type novolaque compatible avec la résine phénolique, dans laquelle le système de polymères comprend environ 55 à environ 95% en poids des solides totaux dans la composition, dans laquelle le système sensibilisateur comprend d'environ 50 à environ 90% en poids de l'agent photosensible et d'environ 10 à environ 50% en poids de l'agent réticulant thermosensible pour la résine phénolique, et dans laquelle l'agent photosensible est la diazocétone et l'agent réticulant thermosensible est le bisarylazide.

4. La composition selon la revendications 1 à 3, dans laquelle le bisarylazide est un composé de formule I ou II:

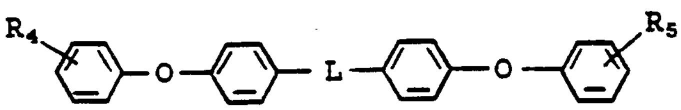 , (I)

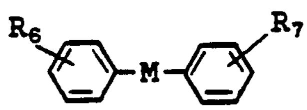 (II)

ou un de leurs mélanges, dans lesquelles L et M sont chacun indépendamment une liaison covalente, $—CH_2—$, $—C(CH_3)_2—$, $—SO_2—$, —CO—, —O—, ou —S—; et

$R_4$, $R_5$, $R_6$ et $R_7$ sont chacun indépendamment —H, $—NH_2$ ou $—N_3$, à la condition que l'un au moins des restes $R_4$ et $R_5$ soit $—N_3$ et l'un au moins des restes $R_6$ et $R_7$ soit $—N_3$.

5. La composition selon les revendications 1 ou 3, dans laquelle la diazocétone est un composé de formule III ou IV:

(III) 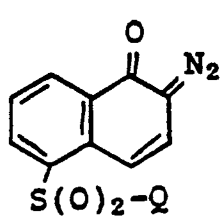 , 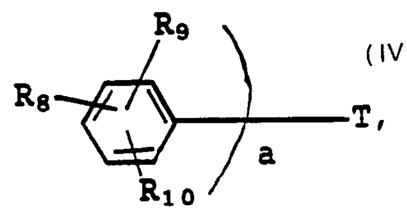 (IV)

ou un de leurs mélanges, dans lesquelles

Q est $—E—(CH_2)_2—O—W$ ou $—E—C_b—X'_{(2b+1)}$;

W est $—CH_3$, $—C_2H_5$, $—(CH_2)_2—O—CH_3$ ou $—(CH_2)_2—O—C_2H_5$;

chaque reste X' est indépendamment —H, —F, —Br, —Cl ou —I;

a est égal à 1 ou 2;

b est égal à 2, 3, 4, 5, 6, 7, 8 ou 9;

T est —(CO)—, —O—, $—CH_2—$, $—C(CH_3)_2—$, $—S(O)_2—$, —S— ou —O—Z—O—, lorsque a est égal à 2; et T est H lorsque a est égal à 1;

Z est $—(CH_2)_2$ ou

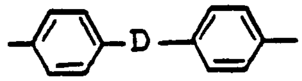 ;

D est —C(O)—, —O—, —$CH_2$—, —$C(CH_3)_2$—, —$S(O)_2$ ou —S—;
chacun des restes $R_8$, $R_9$ et $R_{10}$ est indépendamment —H, —OH, —$NH_2$;

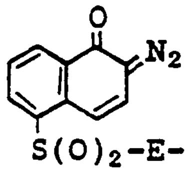 ou 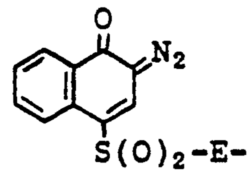 ,

à la condition que l'un au moins des restes $R_8$, $R_9$ ou $R_{10}$ soit

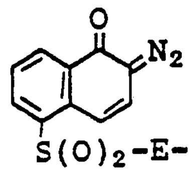

que, lorsque T est —O—Z—O—, chaque reste $R_{10}$ soit H et que lorsque a est égal à 1, $R_{10}$ sont un groupe alkyle monovalent en $C_1$—$C_9$, —$C(CH_3)_3$, —H, —OH, $NH_2$,

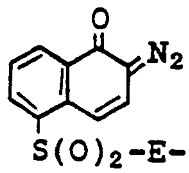 ou 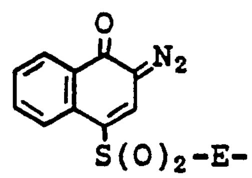 ,

chaque reste E est indépendamment —O— ou —NH—.

6. La composition selon les revendications 1 ou 3, dans laquelle la résine phénolique est représentée pa la formule développée V suivante:

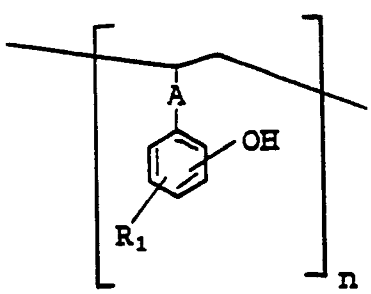 ,

(V)

dans laquelle A est une liaison covalente, —O—, —C(O)O— ou —C(O)$OCH_2$—;
$R_1$ et —H, —F, —Cl, —Br ou —I.

7. La composition selon les revendications 1 ou 3, dans laquelle la résine du type novolaque est représentée pa la formule développée VI suivante:

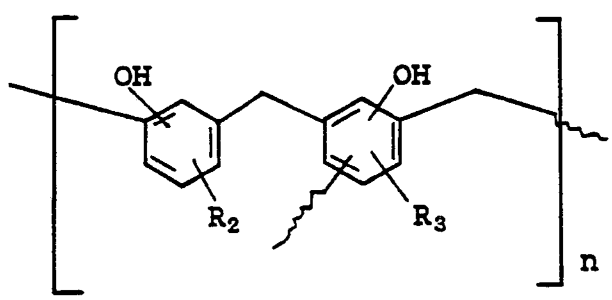

(VI)

dans laquelle $R_2$ et $R_3$ sont chacun indépendamment un groupe alkyle monovalent en $C_1$—$C_4$.

8. La composition selon les revendications 1 ou 3, dans laquelle la résine phénolique a un poids moléculaire moyen en poids d'au moins environ 7 000, la résine phénolique est présente dans la composition en quantité d'environ 40 à environ 95% en poids du sytème de polymères dans la composition et la résine du type novolaque est présente en quantité d'environ 5 à environ 60% en poids du système de polymères dans la composition.

9. La composition selon les revendications 1 ou 3, dans laquelle la teneur totale en solides de la composition est dans la gamme d'environ 15 à environ 35%.

10. La composition selon la revendication 1, dans laquelle la teneur totale en solides est d'environ 15 à environ 35%, dans laquelle le système de polymères comprend environ 40 à environ 95% en poids de la résine phénolique ayant un poids moléculaire moyen en poids d'au moins environ 7 000 et environ 5 à environ 60% en poids de la résine du type novolaque compatible avec la résine phénolique, dans laquelle le système de polymères comprend environ 55 à 95% en poids des solides totaux dans la composition, dans laquelle la résine phénolique est représentée par la formule développée V selon la revendication 6, la résine du type novolaque est représentée par la formule développée VI selon la revendication 7, le système sensibilisateur comprend environ 10 à environ 50% en poids de l'agent réticulant thermosensible pour la résine phénolique et d'environ 50 à 90% en poids de l'agent photosensible, l'agent réticulant thermosensible est un bisarylazide de formule I ou II selon la revendication 4 ou un de leurs mélanges et l'agent photosensible est und diazocétone de formule III ou IV selon la revendication 5 ou un de leurs mélanges.

11. La composition selon l'un quelconque des revendications 1 à 10, dans laquelle le solvant est une cétone aliphatique, un ester aliphatique, un éther de monoalkyle d'alkylèneglycol, un éther de monoalkyle de dialkylèneglycol, un éther de dialkylke d'alkylèneglycol ou un de leurs mélanges.

12. La composition selon l'une quelconque des revendications 1 à 10, dans laquelle le solvant est un mélange d'acétate d'éthylcellosolve, d'acétate de butyle et de xylène.

13. La composition selon l'une quelconque des revendications 1 à 10, dans laquelle le système de polymères comprend environ 15% en poids de la résine du type novolaque et environ 85% en poids de la résine phénolique.

14. La composition selon l'un quelconque des revendications 1 à 10, dans laquelle le système sensibilisateur comprend environ 70% en poids de la diazocétone et environ 30% en poids du bisarylazide.

15. La composition selon l'un quelconque des revendications 1 à 10, dans laquelle le système de polymères comprend environ 65% en poids des solides totaux dans la composition.

16. Un matériau photosensible, comprenant un support recouvert d'une couche comprenant la composition selon la revendication 1, 3 ou 10.

17. Un procédé pour former une image de réserve thermiquement stable, qui consiste à exposer suivant une image le matériau photosensible selon la revendication 16 à des radiations dans le proche ultraviolet, à développer une image en relief positive en mettant en contact la couche exposée avec un révélateur alcalin aqueux, en éliminant ainsi les zones exposées suivant l'image, et ensuite à exposer le matériau photosensible restant à une température élevée pour développer la stabilité thermique de la réserve.

18. Le procédé selon la revendication 17, dans lequel la matière de réserve restante est exposée à une température dans l'intervalle d'environ 80 à environ 160°C pendant environ 10 à environ 45 min.